# EUROPÄISCHE PATENTANMELDUNG

(11) **EP 3 276 680 A1**
(43) Veröffentlichungstag der Anmeldung: **31.01.2018**
(21) Anmeldenummer: 17153015.7
(22) Anmeldetag: 25.01.2017
(51) Int. Cl.: H01L 33/50

(54) **OPTISCHE RAUCHDETEKTION NACH DEM ZWEIFARBEN-PRINZIP MITTELS EINER LEUCHTDIODE MIT EINEM LED-CHIP ZUR LICHTEMISSION UND MIT EINEM LICHTKONVERTER ZUM UMWANDELN EINES TEILS DES EMITTIERTEN LICHTS IN LANGWELLIGERES LICHT**

(71) Anmelder: Siemens Schweiz AG, 8047 Zürich (CH)
(72) Erfinder: Duric, Aleksandar, 6300 Zug (CH); Konrad, Hilmar, 6340 Baar (CH)
(74) Vertreter: Maier, Daniel Oliver

(57) **Zusammenfassung**

Die Erfindung betrifft eine Anordnung (10) zur optischen Rauchdetektion nach dem Zweifarben-Prinzip. Die Anordnung umfasst eine Leuchtdiode (1) und einen Photosensor (2) zur Detektion von Streulicht oder Durchlicht. Die Leuchtdiode ist dazu ausgebildet, Licht in einem ersten Wellenlängenbereich und in einem davon verschiedenen zweiten Wellenlängenbereich zu emittieren. Erfindungsgemäss weist die Leuchtdiode einen LED-Chip (3) zur Emission von Licht im ersten Wellenlängenbereich sowie einen Lichtkonverter (6) zum Umwandeln eines Teils des emittierten Lichts in Licht des zweiten Wellenlängenbereichs auf. Der zweite Wellenlängenbereich weist eine spektrale Halbwertsbreite (BR) von maximal 100 nm auf. In einer besonderen Ausführungsform weist der Lichtkonverter einen phosphoreszierenden Leuchtstoff mit einer optischen Abklinghalbwertszeit (τF) und/oder optischen Anstiegshalbwertszeit (τR) im Bereich von 10 µs bis 50 ms auf. Mithilfe einer Steuereinheit (9) als Teil einer Rauchdetektionseinheit (20) mit erfindungsgemässer Anordnung kann das Zweifarben-Verhältnis aus der Höhe eines abrupten Signalanstiegs bzw. abrupten Signalabfalls (RS) des erfassten Photosensorsignals unmittelbar nach dem Einschalten/Ausschalten der Leuchtdiode ermittelt werden. Die Erfindung betrifft zudem einen Rauchmelder sowie ein optisches Rauchdetektionsverfahren.

## Beschreibung

### BESCHREIBUNGSEINLEITUNG

Die Erfindung betrifft eine Anordnung zur optischen Rauchdetektion nach dem Zweifarben-Prinzip gemäss Patentanspruch 1.

Des Weiteren betrifft die Erfindung eine besondere Verwendung einer Leuchtdiode für die optische Rauchdetektion nach dem Zweifarben-Prinzip gemäss Patentanspruch 14.

### STAND DER TECHNIK

Aus der EP 2 908 298 A1 ist ein Rauchmelder mit einer nach dem Streulichtprinzip arbeitenden Detektionseinheit bekannt, welche eine Leuchtdiode und einen dafür spektral empfindlichen Photosensor in einer Streulichtanordnung aufweist. Die Leuchtdiode umfasst einen ersten LED-Chip und zweiten LED-Chip zum Aussenden eines ersten und zweiten Lichtbündels mit Licht in einem ersten Wellenlängenbereich von 350 bis 500 nm und in einem zweiten Wellenlängenbereich von 665 bis 1000 nm. Beide LED-Chips sind nebeneinander auf einem Chipträger der Leuchtdiode angeordnet und können unabhängig voneinander zur Lichtemission angesteuert werden.

Mittels geeigneter Bewertung der beiden vom Photosensor erfassten Streulichtintensitäten ist nach dem Zweifarben-Verhältnis-Prinzip eine Unterscheidung zwischen Rauch, Staub und Wasserdampf möglich. Dadurch kann bei der Rauchdetektion die Ausgabe eines möglichen Fehlalarms vermieden werden.

Die Nebeneinanderanordnung der beiden LED-Chips auf dem Chipträger führt allerdings nachteilig dazu, dass die beiden emittierten Lichtbündel nicht entlang desselben optischen Pfads verlaufen. Vielmehr treten die beiden Lichtbündel versetzt zur geometrischen Hauptachse der Leuchtdiode und zusätzlich unter einem Winkelversatz von einigen Grad zueinander aus der Leuchtdiode aus. Dadurch resultieren bei der optischen Streulichtrauchdetektion zwei voneinander verschiedene, sich zum Teil überlappende Streulichtzentren. Bei einer Durchlichtmessung ist wegen der Winkelabweichung bereits nach kurzer Messstrecke nur noch eine der beiden Hauptkeulen der Lichtbündel durch den Photosensor erfassbar. Dies führt in beiden Fällen zu messtechnisch grossen Ungenauigkeiten, um die Rauchteilchengrösse und somit den Rauchtyp zu bestimmen.

Davon ausgehend ist es eine Aufgabe der Erfindung, eine verbesserte Anordnung für die optische Rauchdetektion anzugeben, insbesondere eine Anordnung, bei welcher die beiden von der Leuchtdiode ausgesandten Lichtbündel unterschiedlicher Wellenlänge dem gleichen optischen Pfad folgen.

Es ist eine weitere Aufgabe der Erfindung, eine geeignete Verwendung einer Leuchtdiode für die optische Rauchdetektion nach dem Zweifarben-Prinzip anzugeben.

### LÖSUNG DER AUFGABE

Die Aufgabe der Erfindung wird hinsichtlich der Anordnung durch die Merkmale des unabhängigen Patentanspruchs 1 und hinsichtlich der Verwendung durch die Merkmale des unabhängigen Patentanspruchs 14 gelöst.

Vorteile und Ausgestaltungen der Erfindung, die einzeln oder in Kombination miteinander einsetzbar sind, sind Gegenstand der abhängigen Ansprüche.

### BESCHREIBUNG DER ERFINDUNG

Die erfindungsgemässe Anordnung umfasst eine Leuchtdiode sowie einen spektral darauf abgestimmten Photosensor. Die Leuchtdiode umfasst einen LED-Chip zur Emission von Licht in einem ersten Wellenlängenbereich und einen Lichtkonverter zum Umwandeln eines Teils des emittierten Lichts in Licht eines zweiten Wellenlängenbereichs. Der zweite Wellenlängenbereich weist eine spektrale Halbwertsbreite von maximal 100 nm, insbesondere von maximal 50 nm, auf.

Die spektrale Halbwertsbreite wird in der englischen Fachsprache auch als FWHM für "Full Width at Half of Maximum" bezeichnet. Dagegen emittiert der LED-Chip bereits monochromatisches Licht mit einer Hauptwellenlänge.

Ein grosser Vorteil der Erfindung liegt darin, dass das von der Leuchtdiode emittierte Lichtbündel, welches Licht überwiegend im ersten und im zweiten Wellenlängenbereich aufweist, dem gleichen optischen Pfad folgt wie bei einer einfarbigen Leuchtdiode mit einem einzigen LED-Chip.

Ein weiterer grosser Vorteil liegt im denkbar einfachen Aufbau der Leuchtdiode im Vergleich zur fertigungstechnisch aufwändigen und teuren Nebeneinanderanordnung von zwei einfarbigen LED-Chips auf einem LED-Chipträger. Im einfachsten Fall wird lediglich der Lichtkonverter im Rahmen der Massenfertigung einer herkömmlichen weissleuchtenden Leuchtdiode durch einen Lichtkonverter gemäss der Erfindung ersetzt.

Ein weiterer Vorteil liegt im geringeren Energieverbrauch der Leuchtdiode gemäss der Erfindung im Vergleich zu einer weissleuchtenden LED für die optische Branddetektion. Der Grund hierfür ist, dass die für die Erzeugung von grünem, gelbem und orangenem Licht erforderlichen Leuchtstoffe gar nicht vorhanden sind. Folglich wird für deren Emission auch keine elektrische Energie benötigt. Hierbei liegt die Energie- bzw. Quanteneffizienz moderner Leuchtstoffe schon bei über 90 %.

Darüber hinaus vereinfacht sich die elektrische Ansteuerung der Leuchtdiode gegenüber einer Leuchtdiode mit zwei LED-Chips. Zudem entfällt vorteilhaft ein Anschlusskontakt.

Das vom Photosensor detektierte Licht stammt zumindest mittelbar von der Leuchtdiode, d.h. es gelangt mittelbar als Streulicht von zu detektierenden Rauchpartikeln zum Photosensor und/oder auf optisch direktem Wege nach dem Durchlichtoder Extinktionsprinzip zum Photosensor. Der Photosensor ist insbesondere eine Photodiode, vorzugsweise eine Silizium-Photodiode oder eine Silizium-PIN-Photodiode.

Die Leuchtdiode weist einen einzigen LED-Chip zum Aussenden typischerweise von monochromatischem Licht auf. Der LED-Chip ist vorzugsweise als Flächenstrahler ausgebildet. Mit "Flächenstrahler" oder auch Lambert-Strahler ist gemeint, dass das Licht aus einer ebenen Fläche mit einer Lambert'schen Lichtverteilung abgestrahlt wird. Der erste Wellenlängenbereich erstreckt sich vorzugsweise im Bereich von 315 nm bis 490 nm. Spektral entspricht dies dem optischen Bereich von nahem ultravioletten Licht (UV-A) bis zu blaugrünem Licht. Der zweite Wellenlängenbereich erstreckt sich vorzugsweise im Bereich von 640 nm bis 1400 nm. Dies entspricht dem optischen Bereich von rot/orangenem Licht bis zu nahem Infrarotlicht (NIR, IR-A). Der zweite Wellenlängenbereich ist somit langwelliger als der erste Wellenlängenbereich. Ein derartiger Lichtkonverter wird daher auch als "Downconverter" bezeichnet, d.h. der Lichtkonverter absorbiert einen Teil des vom LED-Chip emittierten Lichts und wandelt dieses bzw. setzt dieses in Licht des zweiten Wellenlängenbereichs um.

Vorzugsweise weist der Lichtkonverter einen sogenannten Linienemitter als lumineszierenden Leuchtstoff auf. Ein derartiger Linienemitter emittiert monochromatisches Licht mit einer zweiten Hauptwellenlänge mit einer spektralen Halbwertsbreite im Bereich von 20 bis 50 nm. Dabei erfolgt die Bestimmung des Zweifarben-Verhältnisses bzw. die Bestimmung der Zweifarben-Differenz und somit die Rauchtypbestimmung umso genauer, je schmalbandiger der zweite Wellenlängenbereich ist.

Im Besonderen liegt das Verhältnis des maximalen Lichtstromwerts bei der ersten Hauptwellenlänge zum maximalen Lichtstromwert bei der zweiten Hauptwellenlänge im Bereich von 0.25 bis 1.2, vorzugsweise im Bereich von 0.4 bis 1. Ein bevorzugter Wert liegt bei 0.5. Denn es hat sich gezeigt, dass die Streulichtintensität von "blauem" Licht an zu detektierenden Teilchen bei gleichem spektralen Lichtstromwert deutlich grösser ist als die von "rotem" Licht.

Das Verhältnis des Lichtteils bzw. des Lichtstromwerts des ersten Wellenlängenbereichs, der in Licht des zweiten Wellenlängenbereichs umgewandelt wird, zum gesamten vom LED-Chip emittierten Licht bzw. Lichtstromwert des ersten Wellenlängenbereichs liegt insbesondere in einem Bereich von 0.2 bis 0.6 und vorzugsweise im Bereich von 0.33 bis 0.5. Das Verhältnis dieser beiden in die Umgebung emittierten Lichtstromwerte ist z.B. über die Schichtdicke des Lichtkonverters und/oder über die Konzentration von einem oder mehreren Leuchtstoffen in einer transparenten Matrix des Leuchtstoffs, wie z.B. in Silikon, einstellbar. Mit anderen Worten nehmen der emittierte blaue Lichtstrom mit Zunahme der Schichtdicke und Leuchtstoffkonzentration ab und zugleich der emittierte rote Lichtstrom bis zu einer gewissen Sättigungsgrenze zu.

Vorzugsweise weist die Leuchtdiode eine Symmetrieachse auf, die mit der Hauptabstrahlrichtung des LED-Chips fluchtet. Die Symmetrieachse kann auch als konstruktive Haupt- oder Längsachse bezeichnet werden. Im Fall von gängigen 5- oder 3 mm-Leuchtdioden, die "off the shelf" als massenhaftes Consumerprodukt verkauft werden, ist dies die Rotationssymmetrieachse bezogen auf das Kunststoffgehäuse derartiger Leuchtdioden. Die Leuchtdiode weist typischerweise ein Gehäuse aus einem vorzugsweise transparenten Kunststoff auf. Mit "transparent" ist hier gemeint, dass das Kunststoffgehäuse für das gesamte von der Leuchtdiode emittierte Licht durchlässig ist.

Typischerweise bildet das Gehäuse entlang des Bereichs nach dem Lichtaustritt aus dem LED-Chip eine optische Linse aus.

Alternativ kann die Leuchtdiode eine 3 mm-Leuchtdiode sein. Sie kann weiterhin alternativ für die Oberflächenmontage ausgeführt sein, d.h. als SMD-Leuchtdiode.

Nach einer Ausführungsform weist der Lichtkonverter zumindest einen Leuchtstoff mit lumineszierenden Eigenschaften auf, so dass der relative Lichtstrom Φᵣₑₗ des gesamten emittierten Lichts zwischen einer Hauptwellenlänge λ₁ des ersten Wellenlängenbereichs und einer Hauptwellenlänge λ₂ des zweiten Wellenlängenbereichs einen Lichtstromwert von maximal 15 %, insbesondere von maximal 10 %, bezogen auf einen auf 100 % normierten maximalen Lichtstromwert im gesamten Emissionsspektrum der Leuchtdiode, innerhalb einer Mindestbandbreite von 100 nm nicht überschreitet. Das Emissionsspektrum der Leuchtdiode weist somit eine signifikante spektrale Bandlücke zwischen den beiden "Peaks" des ersten und zweiten Wellenlängenbereichs auf. Durch die Bandlücke sind die beiden Wellenlängenbereiche spektral klar voneinander getrennt, so dass eine präzise Bestimmung des Zweifarben-Verhältnisses bzw. der Zweifarben-Differenz möglich ist.

Der Lichtkonverter ist somit dazu ausgebildet, einen Teil des emittierten Lichts vom LED-Chip in Licht mit vorzugsweise nur einer einzigen Hauptwellenlänge mit maximalem Lichtstromwert in den zweiten Wellenlängenbereich umzuwandeln. Bedingt durch die komplexen quantenmechanischen Energieumwandlungsprozesse im Lichtkonverter kann sich neben der signifikanten Hauptwellenlänge im zweiten Wellenlängenbereich zumindest noch ein spektraler Nebenwipfel mit geringerer Lichtstromwertüberhöhung ausbilden.

Auf dem Fachgebiet der optischen Rauchdetektion werden optische Rauchmelder, die nach dem Zweifarben-Prinzip arbeiten, synonym auch als Blau/Rot-Melder bezeichnet, entsprechend dem "blauen" ersten Wellenlängenbereich und dem "roten" zweiten Wellenlängenbereich. In diesem Sinne kann das von der Leuchtdiode gemäss der vorliegenden Erfindung emittierte Licht auch als Licht der Farbe "Magenta" bezeichnet werden, resultierend durch additive Farbmischung aus blauem und rotem Licht.

Die Idee zur Erfindung geht auf die Verwendung von LED-Systemen mit ausnahmslos blauleuchtenden und rotleuchtenden LEDs in Gewächshäusern zurück, die zusammen magentafarbenes Licht für die Pflanzenbeleuchtung emittieren und individuell für die Pflanzenart in ihrer Helligkeit unterschiedlich angesteuert werden können (siehe z.B. LED-Beleuchtungssysteme der Firma Illumitex Inc., www.illumitex.com). Hintergrund ist, dass das Farbspektrum zwischen "rot" und "blau" nicht für die Photosynthese und somit nicht für das Pflanzenwachstum nutzbar ist. Durch das Weglassen des nicht erforderlichen Farbspektrums reduzieren sich die Energiekosten im Vergleich zur Beleuchtung mit weissen LEDs erheblich.

Die vorliegende Erfindung greift diesen energiesparenden Gedanken des Weglassens der Farben zwischen "blau" und "rot" aus dem weissen Beleuchtungsspektrum der Sonne auf und überträgt ihn auf einen "Blau/Rot-Melder". Die weitere Erkenntnis der Erfindung liegt nun darin, dass das Weglassen der Farben auch dadurch erfolgen kann, indem die für die Farben zwischen "blau" und "rot" massgeblichen Leuchtstoffe im Lichtkonverter einer weissleuchtenden LED erst gar nicht eingebracht werden.

Nach einer Ausführungsform ist der Lichtkonverter direkt auf dem LED-Chip aufgebracht oder beabstandet zum LED-Chip angeordnet. Der Lichtkonverter kann z.B. eine Paste oder Pulverschicht sein, die auf dem LED-Chip aufbringbar ist. Der Lichtkonverter kann z.B. eine für das zu emittierende Licht transparente Grundmasse aus Silikon als Matrix aufweisen, die mit zumindest einem Leuchtstoff versetzt ist. Der Lichtkonverter kann alternativ ein Lichtkonverterplättchen, d.h. ein sogenanntes "Platelet" sein, welches auf dem LED-Chip applizierbar oder beabstandet dazu anbringbar ist.

Vorzugsweise weist der Lichtkonverter zumindest einen fluoreszierenden Leuchtstoff auf. Der Leuchtstoff weist insbesondere anorganische, kristalline Stoffe mit in der Kristallstruktur eingebrachten Dotierungselementen als Störstellen auf. Als Leuchtstoffe (Phosphore) werden feste Stoffe wie Pulver bezeichnet, die durch Lichtanregung Lumineszenz zeigen. Ein fluoreszierender Leuchtstoff zeigt eine spontane, als Fluoreszenz bezeichnete Emission von Licht kurz nach der optischen Anregung. Die Zeitdauer einer solchen Fluoreszenz liegt typischerweise unter 1 Mikrosekunde.

Leuchtstoffe können z.B. auf Nitriden, Yttrium-Aluminium-Granat (YAG) oder Silikaten basieren. Sie können z.B. mit Europium (Eu²⁺) oder mit Mangan (Mn²⁺, Mn⁴⁺) dotiert sein.

In der Veröffentlichung der US 2011/0255265 A1 ist beispielhaft die chemisch/kristalline Zusammensetzung einer Vielzahl von Leuchtstoffen für die Erzeugung von gelbem, grünem, orangenem oder rotem Licht aus blauem oder UV(A)-Licht für die Lichtanregung beschrieben. Bekannte Hersteller einer Vielzahl von Leuchtstoffen für die Lichtkonversion bei LEDs sind Intematix Corp., Lumiled Holding B.V. oder General Electric Company. Ein Hersteller für Infrarot-Leuchtstoffe ist z.B. die Fa. Tailorlux GmbH.

Alternativ oder zusätzlich kann der Lichtkonverter einen Leuchtstoff aus Quantenpunkten (engl. quantum dot) mit einer nanoskopischen Materialstruktur, typischerweise aus einem Halbleitermaterial wie InGaAs, CdSe oder GaInP/InP aufweisen.

Aus dem Vortrag "Quantum Dots, Product Form Factors, Green Manufacturing" von Seth Coe-Sullivan, veröffentlicht am 08.05.2014 auf dem 2014 Solid-State Lighting Manufacturing R&D Workshop in San Diego, ist eine Reihe kommerzieller Quantenpunkt-Leuchtstoffe für Farbdisplays bekannt, die sehr schmalbandiges rotes, grünes und blaues Licht emittieren.

Einer weiteren, besonders vorteilhaften Ausführungsform zufolge weist der Lichtkonverter zumindest einen phosphoreszierenden Leuchtstoff (Luminophore) auf. Der Leuchtstoff weist insbesondere anorganische, kristalline Stoffe mit in der Kristallstruktur eingebrachten Dotierungselementen als Störstellen auf. Im Gegensatz zur Fluoreszenz zeigen phosphoreszierende Leuchtstoffe eine zeitverzögerte Lichtemission nach optischer kurzwelligerer Anregung. Bei der Phosphoreszenz hingegen kommt es im Unterschied zur Fluoreszenz zu einem Nachleuchten, das je nach Leuchtstoff bis zu mehreren Minuten dauern kann. Umgekehrt benötigt ein phosphoreszierender Leuchtstoff auch eine gewisse optische Aufladezeit, um die durch kurzwelligere optische Erregung eingebrachte Energie basierend auf quantenmechanischen Prozessen auf ein höheres Energie zu heben.

Derartige phosphoreszierende Leuchtstoffe sind beispielsweise im Vortrag "Luminescence and Energy Transfer of Eu- and Mn-Coactivated CaAl2Si2O8 as a Potential Phosphor for White-Light UVLED" von Woan-Jen Yang, Liyang Luo, Teng-Ming Chen und Niann-Shia Wang, veröffentlicht am 21.06.2005 von der American Chemical Society im Internet beschrieben. Dort ist auch offenbart, dass die Nachleuchtdauer von Mn²⁺ als optischer Koaktivator zu Eu²⁺ mit dessen mengenverhältnismässiger Zunahme abnimmt und somit einstellbar ist.

Aus dem Vortrag "Warm-white-light emitting diode utilizing a single-phase full-color Ba3MgSi2O8:Eu2+, Mn2+ phosphor" von J. S. Kim, P. E. Jeon, J. C. Choi and H. L. Park, veröffentlicht 2004 in den Applied Physics Letters, Vol. 84, S. 2931, ist ein Leuchtstoff für weissleuchtende LEDs offenbart, der hauptsächlich rotes Licht mit einer Nachleuchtzeit von 750 µs emittiert.

Aus dem Vortrag "Characterization for Manufacturing Controls, and Usage in High Performance LED Systems" von Ashfaq Chowdhury, veröffentlicht am 08.05.2014 auf dem 2014 Solid-State Lighting Manufacturing R&D Workshop in San Diego, ist ein sehr schmalbandiger rotleuchtender Leuchtstoff auf Basis von Kaliumfluorsilikaten (englisch PFS für "potassium fluorosilicate") mit einer exponentiell abfallenden Abklingzeitkonstante sowie mit einer entsprechend umgekehrt exponentiell zunehmenden Anstiegszeitkonstante von ca. 8.7 ms bekannt.

Aus der Veröffentlichung der US 2012/0229038 A1 sind verschiedene Leuchtstoffe für weissleuchtende LEDs beschrieben, die mit einer Wechselspannung von 50 Hz oder 60 Hz flackerfrei betrieben werden können. Die dortigen Leuchtstoffe weisen eine Nachleuchtzeit im Bereich von 1 bis 10 ms auf.

Bedingt durch die komplexen optisch/chemischen Energieumwandlungsprozesse im Lichtkonverter können sich fluoreszierende und phosphoreszierende Umwandlungsprozesse überlagern.

Nach einer Ausführungsform weist der zumindest eine Leuchtstoff, insbesondere mit phosphoreszierenden Eigenschaften, eine Abklinghalbwertszeit für das Nachleuchten des Leuchtstoffs nach Wegfall der optischen Erregung durch den LED-Chip im Bereich von 10 µs bis 50 ms auf, insbesondere in einem Bereich von 50 µs bis 500 µs. Alternativ oder auch zusätzlich weist der zumindest eine Leuchtstoff eine Anstiegshalbwertszeit für das optische Aufladen des Leuchtstoffs beginnend mit dieser optischen Erregung und im Bezug auf einen maximalen Erregungssättigungswert im Bereich von 10 µs bis 50 ms, insbesondere in einem Bereich von 50 µs bis 500 µs, auf.

Die Abklinghalbwertszeit bezeichnet als charakteristisches Mass diejenige Zeitspanne, nach welcher der Lichtstromwert des vom Leuchtstoff emittierten Lichts nach Wegfall der Erregung durch Licht des ersten Wellenlängenbereichs um die Hälfte zurückgegangen ist. Die Anstiegshalbwertszeit bezeichnet als weiteres charakteristisches Mass diejenige Zeitspanne, nach welcher der Lichtstromwert des vom Leuchtstoff emittierten Lichts beginnend mit der Erregung durch Licht des ersten Wellenlängenbereichs, d.h. beginnend mit einem Lichtstromwert von 0, die Hälfte des maximalen Lichtstromwerts erreicht, der nachfolgend bei stationärer Erregung asymptotisch erreicht wird.

Die Aufgabe der Erfindung wird weiterhin durch eine Rauchdetektionseinheit gelöst, welche eine erfindungsgemässe Anordnung aufweist. Die Steuereinheit ist mit der Leuchtdiode und mit dem Photosensor verbunden, insbesondere signal- oder datentechnisch. Die Steuereinheit ist dazu eingerichtet bzw. programmiert, die Leuchtdiode zur Lichtemission (elektrisch) anzusteuern, ein Photosensorsignal des Photosensors zu erfassen, eine erste und zweite Lichtintensität für den ersten und zweiten Wellenlängenbereich aus einer zeitlichen Analyse des Photosensorsignals zu bilden, darauf basierend ein Zweifarben-Verhältnis oder eine Zweifarben-Differenz zu bilden, und das Zweifarben-Verhältnis oder die Zweifarben-Differenz bei der Brandalarmierung mit zu berücksichtigen.

Die Steuereinheit ist vorzugsweise ein Mikrocontroller. Sie ist dazu eingerichtet bzw. programmiert, den LED-Chip zur Lichtemission elektrisch gepulst anzusteuern. Durch Verhältnis- oder Differenzbildung aus den beiden jeweiligen, der "Farbe" zugeordneten empfangenen Signalamplituden des Photosensors ist dann eine Bestimmung einer äquivalenten Partikelgrösse möglich. Diese Partikelgrösse kann dann bei der Brandalarmierung, d.h. bei der Generierung und Ausgabe eines Brandalarms durch die Steuereinheit mit berücksichtigt werden. Beispielsweise kann die Steuereinheit dazu eingerichtet sein, durch Vergleich der Lichtintensität des ersten "blauen" Wellenlängenbereichs und/oder der Lichtintensität des zweiten "roten" Wellenlängenbereichs mit einem jeweiligen Mindestkonzentrationswert eine entsprechende Warnmeldung und/oder Alarmmeldung auszugeben.

Generell können die jeweiligen Verarbeitungsschritte für die zeitliche Ansteuerung des LED-Chips sowie die synchronisierte Erfassung und Auswertung des Photosensorsignals sowie die Ausgabe eines Brandalarm und/oder einer Warnmeldung durch geeignete, auf dem Mikrocontroller ausführbare Programmschritte realisiert sein.

Nach einer Ausführungsform der Rauchdetektionseinheit ist der Photosensor als Zweikanal-Photosensor ausgebildet und weist zwei Photosensoreinheiten auf. Der Zweikanal-Photosensor ist vorzugsweise einstückig ausgebildet. Die beiden Photosensoreinheiten sind typischerweise aneinandergrenzend angeordnet und optisch gleich ausgerichtet. Es ist zumindest einer der Photosensoreinheiten ein optisches Filter vorgeschaltet, welches Licht im ersten Wellenlängenbereich oder im zweiten Wellenlängenbereich passieren lässt. Mit anderen Worten kann nur einem der beiden Photosensoreinheiten ein optisches Filter vorgeschaltet sein, welches im Wesentlichen nur Licht des ersten oder zweiten Wellenlängenbereichs passieren lässt. Es können auch der ersten Photosensoreinheit ein optisches Filter für den ersten Wellenlängenbereich und der zweiten Photosensoreinheit ein optisches Filter für den zweiten Wellenlängenbereich vorgeschaltet sein. Die Steuereinheit ist dazu eingerichtet bzw. programmiert, aus den beiden erfassten Streulichtintensitäten des Photosensors das Zweifarben-Verhältnis oder die Zweifarben-Differenz zu bilden. Das jeweilige optische Filter kein z.B. ein Filterplättchen oder ein Farblack sein, das bzw. der auf der jeweiligen Photosensoreinheit angebracht oder aufgetragen wird. Ein Beispiel für einen zweikanaligen Photosensor ist die Photodiode vom Typ BPW 34B, SFH 221 oder SFH 7771 der Fa. OSRAM.

Nach einer dazu alternativen Ausführungsform ist der Photosensor als Einkanal-Photosensor ausgebildet, d.h. ein "normaler" Photosensor. Es ist dem Einkanal-Photosensor ein elektrisch umschaltbares optisches Filter vorgeschaltet, welches zum Passieren von Licht zumindest eines der beiden Wellenlängenbereiche in alternierenden Phasen eingerichtet ist. Die Steuereinheit ist dazu eingerichtet, das optische Filter alternierend elektrisch anzusteuern und aus dem jeweiligen, den alternierenden Phasen zeitlich zugeordneten Photosensorsignal das Zweifarben-Verhältnis oder die Zweifarben-Differenz zu bilden. Ein Beispiel für einen einkanaligen Photosensor ist die Photodiode vom Typ BPW 34B der Fa. OSRAM.

Nach einer weiteren, zu den beiden vorherigen Ausführungsformen alternativen Ausführungsform ist die Steuereinheit dazu eingerichtet, das Zweifarben-Verhältnis oder die Zweifarben-Differenz aus der Höhe eines abrupten Signalanstiegs des erfassten Photosensorsignals unmittelbar nach dem Einschalten der Leuchtdiode zu ermitteln. Sie ist alternativ oder zusätzlich dazu eingerichtet, das Zweifarben-Verhältnis oder die Zweifarben-Differenz aus der Höhe eines abrupten Signalabfalls des erfassten Photosensorsignals unmittelbar nach dem Ausschalten der Leuchtdiode zu ermitteln. Mit "abrupt" ist gemeint, dass der Signalanstieg bzw. der Signalabfall um die zuvor genannte Höhe in einem Zeitraum von weniger als 10 µs, vorzugsweise in einem Zeitraum von weniger als 3 µs erfolgt.

Der besondere Vorteil bei dieser Ausführungsform ist, dass mit einer einzigen Leuchtdiode, die nur einen LED-Chip aufweist, und mit einem einzigen einkanaligen, d.h. herkömmlichen Photosensor, eine Rauchdetektion nach dem Zweifarben-Prinzip möglich ist.

Die Leuchtdiode emittiert unmittelbar nach dem Einschalten nur "blaues" Licht, also Licht des ersten Wellenlängenbereichs. Dieses "blaue" Licht wird durch den Photosensor erfasst, sei es direkt oder als Streulicht von zu detektierenden Rauchpartikeln. Unmittelbar nachfolgend emittiert die Leuchtdiode zunehmend auch "rotes" Licht, also Licht des zweiten Wellenlängenbereichs, welches vom Leuchtstoff im Lichtkonverter stammt und welches gleichfalls durch den Photosensor erfasst wird. Mit anderen Worten wird das gesamte von der Leuchtdiode emittierte Licht mit der Zeit mehr und mehr "magentafarben". Der gesamte von der Leuchtdiode emittierte Lichtstrom springt somit unmittelbar nach dem Einschalten auf einen "blauen" Lichtstromwert und erreicht nach 5 bis 7 Anstiegshalbwertszeiten asymptotisch einen maximalen "magentafarbenen" Lichtstromwert.

Umgekehrt erlischt nach dem Ausschalten der Leuchtdiode unmittelbar der von der Leuchtdiode emittierte "blaue" Lichtanteil des gesamten emittierten "magentafarbenen" Lichts. Unmittelbar nachfolgend emittiert die Leuchtdiode noch abnehmend "rotes" Licht, welches vom Leuchtstoff im Lichtkonverter stammt. Der gesamte von der Leuchtdiode emittierte Lichtstrom springt somit unmittelbar nach dem Ausschalten der Leuchtdiode von einem maximalen "magentafarbenen" Lichtstromwert auf einen "roten" Lichtstromwert und erreicht nach 5 bis 7 Abklinghalbwertszeiten asymptotisch den Lichtstromwert 0.

Die Aufgabe der Erfindung wird weiter durch einen Streulichtrauchmelder mit einem Gehäuse und mit einer im Gehäuse aufgenommenen erfindungsgemässen Rauchdetektionseinheit gelöst. Die Leuchtdiode und der Photosensor sind in einer Streulichtanordnung angeordnet und auf ein gemeinsames Streulichtzentrum ausgerichtet. Das Gehäuse weist Raucheintrittsöffnungen für den Durchtritt von Umgebungsluft in das Innere des Gehäuses auf. Das Gehäuse ist gegen das Eindringen von direktem Umgebungslicht in das Innere des Gehäuses abgeschirmt.

Weiter wird die Aufgabe der Erfindung durch einen Extinktions-Rauchmelder, also durch einen Durchlichtrauchmelder, mit einem Gehäuse und mit einer im Gehäuse aufgenommenen erfindungsgemässen Rauchdetektionseinheit gelöst. Die Leuchtdiode und der Photosensor sind derart angeordnet, dass der Photosensor direktes Licht von der Leuchtdiode detektiert. Die Leuchtdiode und der Photosensor liegen sich somit optisch gegenüber, wie z.B. geometrisch direkt oder über einen Spiegel. Das Gehäuse weist Raucheintrittsöffnungen für den Durchtritt von Umgebungsluft in das Innere des Gehäuses auf. Das Gehäuse ist gegen das Eindringen von direktem Umgebungslicht in das Innere des Gehäuses abgeschirmt.

Die Aufgabe der Erfindung wird weiterhin durch einen offenen Streulichtrauchmelder mit einem Gehäuse und mit einer am Gehäuse aufgenommenen erfindungsgemässen Rauchdetektionseinheit gelöst. Die Leuchtdiode und der Photosensor sind im oder am Gehäuse angeordnet und optisch auf ein gemeinsames Streulichtzentrum ausgerichtet. Das Streulichtzentrum liegt ausserhalb des Streulichtrauchmelders im Freien und somit auch ausserhalb des Gehäuses des Streulichtrauchmelders.

Die Aufgabe der Erfindung wird weiterhin durch eine geeignete Verwendung einer Leuchtdiode für die optische Rauchdetektion nach dem Zweifarben-Prinzip gelöst, bei der die Leuchtdiode einen (einzigen) LED-Chip zur gepulsten Lichtemission in einem ersten Wellenlängenbereich sowie einen Lichtkonverter mit zumindest einem Leuchtstoff zum Umwandeln eines Teils des emittierten Lichts in Licht eines zweiten Wellenlängenbereichs aufweist. Der zweite Wellenlängenbereich weist eine spektrale Halbwertsbreite von maximal 100 nm, insbesondere von maximal 50 nm, auf.

Insbesondere wird nach einer Verfahrensvariante die Leuchtdiode zur gepulsten Lichtemission mit sich zeitlich ändernden Lichtanteilen des ersten und zweiten Wellenlängenbereichs innerhalb eines Lichtpulses verwendet. Dabei weist der zumindest eine Leuchtstoff eine Abklinghalbwertszeit für das Nachleuchten des Leuchtstoffs nach Wegfall der optischen Erregung durch den LED-Chip oder eine Anstiegshalbwertszeit für das optische Aufladen des Leuchtstoffs beginnend mit der optischen Erregung durch den LED-Chip jeweils im Bereich von 10 µs bis 50 ms, insbesondere in einem Bereich von 50 µs bis 5 ms, auf. Typischerweise sind die Abklinghalbwertszeit und die Anstiegshalbwertszeit für einen Leuchtstoff gleich. Es wird das Zweifarben-Verhältnis oder die Zweifarben-Differenz aus den sich zeitlich ändernden Lichtanteilen innerhalb eines Lichtpulses gebildet.

### FIGURENBESCHREIBUNG

Die Erfindung sowie vorteilhafte Ausführungen der vorliegenden Erfindung werden am Beispiel der nachfolgenden Figuren erläutert. Dabei zeigen:
- FIG 1: eine bekannte Anordnung zur optischen Rauchdetektion nach dem Zweifarben-Prinzip mit einer Leuchtdiode mit zwei einfarbigen LED-Chips und Photosensor,
- FIG 2: ein Beispiel für eine Leuchtdiode gemäss der Erfindung mit einem einzigen LED-Chip und mit einem darauf aufgebrachten Lichtkonverter,
- FIG 3: ein Beispiel für eine Leuchtdiode gemäss der Erfindung mit LED-Chip und Lichtkonverterplättchen,
- FIG 4: ein Beispiel für eine Leuchtdiode gemäss der Erfindung in SMD-Bauweise für die Oberflächenmontage,
- FIG 5: eine zweiteilige Ausführungsform einer erfindungsgemässen Leuchtdiode mit separatem LED-Leuchtkörper und dazu beabstandeter Linse mit Lichtkonverter,
- FIG 6: das optische Spektrum zweier herkömmlicher weissleuchtender Leuchtdioden (cool white, warm white),
- FIG 7: das optische Spektrum einer beispielhaften Leuchtdiode gemäss der Erfindung mit zwei beabstandeten, spektral dominierenden Wellenlängenbereichen im violetten und im nahen infraroten Bereich,
- FIG 8: das optische Spektrum einer weiteren beispielhaften Leuchtdiode gemäss der Erfindung mit zwei beabstandeten, spektral dominierenden Wellenlängenbereichen im violetten und im roten Bereich,
- FIG 9: eine Ausführungsform der erfindungsgemässen Anordnung zur optischen Streulichtdetektion mit einer Leuchtdiode mit fluoreszierendem Leuchtstoff und mit einem zweikanaligen Photosensor,
- FIG 10: eine weitere Ausführungsform der erfindungsgemässen Anordnung zur optischen Streulichtdetektion mit einer Leuchtdiode mit fluoreszierendem Leuchtstoff, mit einem einkanaligen Photosensor und mit einem elektrisch umschaltbarem optischen Filter,
- FIG 11: ein Zeitdiagramm, welches die gepulste Ansteuerung einer Leuchtdiode mit phosphoreszierendem Leuchtstoff gemäss der Erfindung sowie eine im Vergleich zur spontanen Emission im ersten Wellenlängenbereich zeitverzögerte und nachleuchtende Emission im zweiten Wellenlängenbereich zeigt,
- FIG 12: eine Ausführungsform der erfindungsgemässen Anordnung zur optischen Streulichtdetektion mit einer Leuchtdiode mit phosphoreszierendem Leuchtstoff und mit einem einkanaligen Photosensor,
- FIG 13: eine Ausführungsform der erfindungsgemässen Anordnung zur Durchlichtmessung entlang einer Messstrecke mit einer Leuchtdiode mit fluoreszierendem Leuchtstoff und mit zweikanaligem Photosensor,
- FIG 14: ein Beispiel für eine Steuereinheit für eine Rauchdetektionseinheit gemäss der Erfindung, und
- FIG 15: ein Beispiel für eine Rauchdetektionseinheit geschlossener Bauart mit einer erfindungsgemässen Streulichtanordnung.

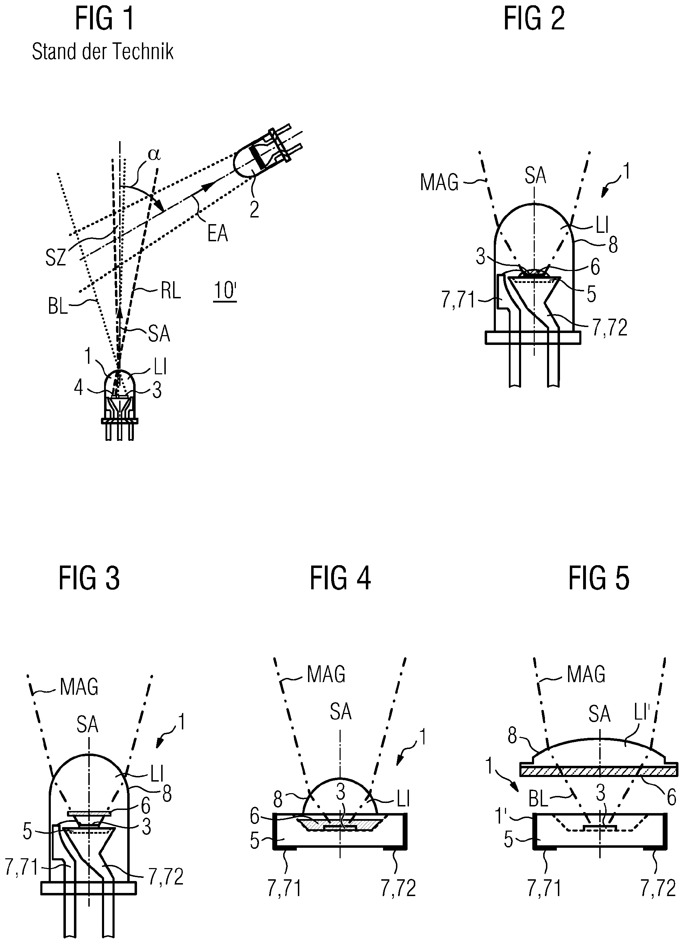

FIG 1 zeigt eine bekannte Anordnung 10' zur optischen Rauchdetektion nach dem Zweifarben-Prinzip mit einer Leuchtdiode 1 mit zwei einfarbigen LED-Chips 3, 4 und mit einem Photosensor 2. Bei der gezeigten Streulichtanordnung ist der Photosensor 2 unter einem Streulichtwinkel α von 60° zur Leuchtdiode 1 zur Streulichtdetektion angeordnet. Mit EA ist der optische Erfassungsbereich des Photosensors 2 bezeichnet.

Der erste LED-Chip 3 emittiert ein erstes "blaues" Lichtbündel BL in einem Wellenlängenbereich von 350 nm bis 500 nm. Der zweite LED-Chip 4 emittiert ein zweites "rotes" Lichtbündel RL in einem Wellenlängenbereich von 665 nm bis 1000 nm. Beide LED-Chips 3, 4 sind nebeneinander angeordnet. Mit LI ist eine im Gehäuse der Leuchtdiode 1 ausgeformte Linse bezeichnet, welche die von den beiden LED-Chips 3, 4 emittierten Lichtbündel BL, RL fokusiert. Die Nebeneinanderanordnung der beiden LED-Chips 3, 4 auf dem Chipträger führt allerdings nachteilig dazu, dass die beiden emittierten Lichtbündel BL, RL nicht entlang desselben optischen Pfads verlaufen. Vielmehr treten die beiden Lichtbündel BL, RL versetzt zur geometrischen Hauptachse SA der Leuchtdiode 1 und zusätzlich unter einem Winkelversatz von einigen Grad zueinander aus der Leuchtdiode 1 aus. Die Leuchtdiode 1 "schielt" daher.

FIG 2 zeigt ein Beispiel für eine Leuchtdiode 1 gemäss der Erfindung mit einem einzigen LED-Chip 3 und mit einem darauf aufgebrachten Lichtkonverter 6. Der LED-Chip 3 ist auf einem Chipträger 5 der Leuchtdiode 1 angeordnet und vorzugsweise ein Flächenstrahler oder Lambert-Strahler. Mit "Flächenstrahler" ist hier gemeint, dass das Licht aus einer ebenen Fläche mit einer Lambert' schen Lichtverteilung abgestrahlt wird. Der LED-Chip 3 kann alternativ auch ein sogenannter Kantenstrahler sein. Mit SA ist die geometrische Hauptachse bzw. Symmetrieachse der Leuchtdiode 1 bezeichnet, die mit der optischen Sendeachse der Leuchtdiode 1 zusammenfällt. Vorzugsweise ist der LED-Chip 3 orthogonal zur geometrischen Hauptachse SA angeordnet. Weiter vorzugsweise verläuft die geometrische Hauptachse SA der Leuchtdiode 1 durch die geometrische Mitte des LED-Chips 3. Die Leuchtdiode 1 umfasst weiter ein transparentes LED-Gehäuse 8, vorzugsweise aus Kunststoff oder aus Glas, in dem die Anschlusskontakte 7, 71, 72 sowie der Chipträger 5 angeordnet sind. Im Bereich des Lichtaustritts aus der Leuchtdiode 1 ist im vorliegenden Beispiel eine optische Linse LI zur Lichtbündelung im LED-Gehäuse 2 ausgeformt.

Erfindungsgemäss ist der LED-Chip 3 zur Emission von Licht in einem ersten Wellenlängenbereich und der Lichtkonverter zum Umwandeln eines Teils des emittierten Lichts in Licht eines zweiten Wellenlängenbereichs ausgebildet. Der zweite Wellenlängenbereich weist eine spektrale Halbwertsbreite BR von maximal 100 nm, vorzugsweise von maximal 50 nm auf. Der erste Wellenlängenbereich erstreckt sich im Bereich von 315 nm bis 490 nm, was spektral nahem ultravioletten Licht (UV-A) bis zu blaugrünem Licht entspricht. Der zweite Wellenlängenbereich erstreckt sich im Bereich von 640 nm bis 1400 nm, was spektral rot/orangenem Licht bis nahem Infrarotlicht (NIR, IR-A) entspricht. Mit MAG ist ein aus der additiven Farbüberlagerung aus "blau" und "rot" resultierendes "magentafarbenes" Lichtbündel bezeichnet. Dessen Hauptabstrahlrichtung fällt mit der geometrischen Hauptachse SA bzw. mit der optischen Sendeachse der Leuchtdiode 1 zusammen.

FIG 3 zeigt ein Beispiel für eine Leuchtdiode 1 gemäss der Erfindung mit einem dem LED-Chip 3 optisch nachgeschalteten Lichtkonverterplättchen 3. Das Lichtkonverterplättchen 3, welches in der Fachsprache auch als Platelet bezeichnet, ist parallel zum LED-Chip 3 und vorzugsweise in einem Abstand im Bereich von 0.5 bis 3 mm zu diesem angeordnet.

FIG 4 zeigt ein Beispiel für eine Leuchtdiode 1 gemäss der Erfindung in SMD-Bauweise für die Oberflächenmontage. Im vorliegenden Beispiel weist die SMD-Leuchtdiode 1 eine halbkugelförmige optische Linse LI zur besonders starken Bündelung des emittierten magentafarbenen Lichtbündels MAG auf.

FIG 5 zeigt eine zweiteilige Ausführungsform einer erfindungsgemässen Leuchtdiode 1 mit einem LED-Leuchtkörper 1' und einer dazu beabstandeter Linseneinheit LI' mit einem aufgebrachten Lichtkonverter 6. Beide Bauteile 1', LI' sind einstückige Bauelemente. Vorzugsweise ist die Linseneinheit LI' dazu ausgestaltet, um in einer Aufnahme einer nicht weiter gezeigten Blende zur Begrenzung des emittierten Lichtbündels MAG eingesetzt zu werden. Der gezeigte LED-Leuchtkörper 1' emittiert folglich nur ein blaues Lichtbündel BL. Dieses trifft auf die in der vorliegenden FIG 5 gezeigte Unterseite der Linseneinheit LI' mit dem dort aufgebrachten Lichtkonverter 6. Das vom Lichtkonverter 6 emittierte "rote" Licht überlagert sich additiv mit dem "blauen" Licht vom LED-Leuchtkörper 1' zu einem magentafarbenen Lichtbündel MAG.

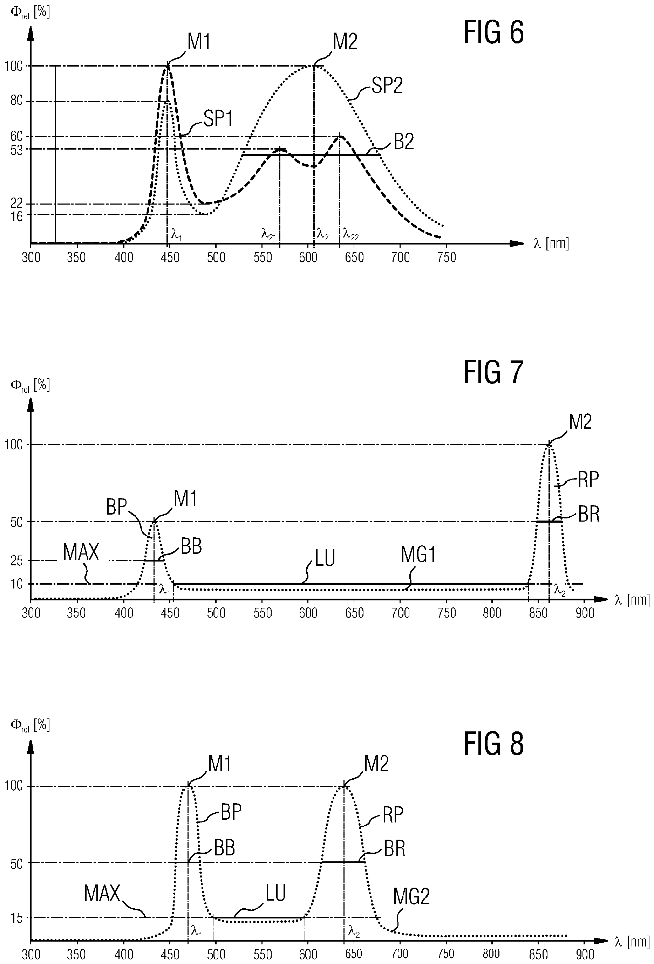

FIG 6 zeigt das optische Spektrum SP1, SP2 zweier herkömmlicher weissleuchtender Leuchtdioden (LED) vom Typ "cool white" und vom Typ "warm white". Das Spektrum SP1 der Leuchtdiode vom Typ "cool white" ist gestrichelt dargestellt. Das Spektrum SP2 der Leuchtdiode vom Typ "warm white" ist punktiert dargestellt. Mit λ ist Abszisse der beiden Spektren SP1, SP2 in Nanometer und mit Φᵣₑₗ der relative Lichtstrom Φᵣₑₗ als Ordinate bezeichnet. Letzerer ist auf 100 % des jeweiligen Maximums M1, M2 der beiden Spektren SP1, SP2 normiert.

Ziel derartiger Leuchtdioden ist eine möglichst breitbandige Abstrahlung in einem für den Menschen sichtbaren optischen Bereich zu Beleuchtungszwecken, allerdings mit einer Betonung auf eine mehr blaue, "kühlere" Farbtemperatur von typischerweise 4000 K oder auf eine mehr rote, "wärmere" Farbtemperatur von typischerweise 2700 K. Dies wird erreicht durch eine Komposition mehrerer Leuchtstoffe, die einen Teil des von einem "blauen" LED-Chip im ersten Wellenlängenbereich mit der Hauptwellenlänge λ₁ von etwa 450 nm emittierten Lichts für den Typ "cool white" in zwei Wellenlängenbereiche mit den Hauptwellenlängen λ₂₁ und λ₂₂ breitbandig umsetzt. Die eine Hauptwellenlänge λ₂₁ liegt bei etwa 570 nm und die andere bei etwa 630 nm. Für den Typ "warm white" liegt die Hauptwellenlänge λ₂ des zweiten Wellenlängenbereichs bei etwa 610 nm. Entsprechend breit ist die spektrale Halbwertsbreite B2. Sie liegt bei ca. 150 nm bei dem beispielhaften Spektrum SP2.

FIG 7 zeigt das optische Spektrum MG1 einer beispielhaften Leuchtdiode gemäss der Erfindung mit zwei beabstandeten, spektral dominierenden Wellenlängenbereichen BP, RP im violetten und im nahen infraroten Bereich. Auch wenn beide Wellenlängenbereiche BP, RP nicht direkt der Farbe "blau" entsprechen bzw. gar nicht im optisch sichtbaren Bereich für das menschliche Auge liegen, werden zum besseren Verständnis der Erfindung weiterhin die Farben "blau" und "rot" verwendet, die das Zweifarbenprinzip repräsentieren sollen.

Im vorliegenden Beispiel emittiert der "blaue" LED-Chip Licht mit einer Hauptwellenlänge λ₁ bei 430 nm. Es handelt sich hier im Wesentlichen um monochromatisches Licht, welches typisch für die Lichtaussendung von einfarbigen LED-Chips ist. Die spektrale Halbwertsbreite BB liegt hier bei ca. 20 nm. Mit M1 ist das Maximum des relativen Lichtstroms Φᵣₑₗ bei 430 nm bezeichnet. Dieser gezeigte "blaue Peak" BP stellt den Lichtanteil dar, der nicht vom Lichtkonverter in Licht des zweiten Wellenlängenbereichs umgesetzt worden ist. Der zweite Wellenlängenbereich ist als "roter Peak" RP im rechten Teil der FIG 7 zu sehen. Er weist ein ausgeprägtes Maximum M2 bei einer zweiten Hauptwellenlänge λ₂ bei ca. 860 nm auf und ist doppelt so gross wie das erste Maximum M1 bei 50 %.

Wie die FIG 7 weiter zeigt, liegt die spektrale Halbwertsbreite BR des rechten roten Peaks RP bzw. des zweiten Wellenlängenbereichs bei ca. 30 nm. Vorzugsweise weist der Lichtkonverter einen Linienemitter mit geeigneten lumineszierenden Eigenschaften auf, um das anregende Licht des ersten Wellenlängenbereichs vorzugsweise nur in schmalbandiges Licht des zweiten Wellenlängenbereichs umzusetzen. Gemäss der Erfindung resultieren daraus zwei weit beabstandete, schmalbandige Wellenlängenbereiche BP, RP mit einer Mindestbandbreite bzw. Bandlücke LU von mehr 350 nm. Dadurch ist eine besonders effektive, energiesparende und präzise Rauchtypbestimmung nach dem Zweifarbenprinzip möglich. Die Mindestbandbreite LU ist in diesem Beispiel auf einen maximalen Lichtstromwert MAX von 10 % bezogen, innerhalb der die spektralen Lichtstromanteile im gezeigten "magentafarbenen" Spektrum MG1 den maximalen Lichtstromwert MAX nicht überschreiten.

FIG 8 zeigt das optische Spektrum MG2 einer weiteren beispielhaften Leuchtdiode gemäss der Erfindung mit zwei beabstandeten, spektral dominierenden Wellenlängenbereichen BP, RP im violetten und im roten Bereich. Im Vergleich zur vorherigen Ausführungsform liegen die beiden Wellenlängenbereiche BP, RP im optisch sichtbaren Bereich. Im Beispiel der FIG 8 emittiert der "blaue" LED-Chip Licht mit einer Hauptwellenlänge λ₁ bei 470 nm. Die spektrale Halbwertsbreite BB liegt hier bei ca. 25 nm. Mit M1 ist das Maximum des relativen Lichtstroms Φᵣₑₗ bei 470 nm bezeichnet und ist genau so gross wie das Maximum M2 des im rechten Teil der FIG 8 gezeigten spektralen "blauen Peaks" bei einer Hauptwellenlänge λ₂ bei ca. 640 nm. Weiter liegt die spektrale Halbwertsbreite BR des rechten roten Peaks RP bzw. des zweiten Wellenlängenbereichs bei ca. 45 nm. Es resultieren gemäss der Erfindung zwei beabstandete, schmalbandige Wellenlängenbereiche BP, RP mit einer Mindestbandbreite bzw. Bandlücke LU von 100 nm. Die Mindestbandbreite LU ist im vorliegenden Beispiel auf einen maximalen Lichtstromwert MAX von 15 % bezogen, innerhalb der die spektralen Lichtstromanteile im gezeigten "magentafarbenen" Spektrum MG2 den maximalen Lichtstromwert MAX nicht überschreiten.

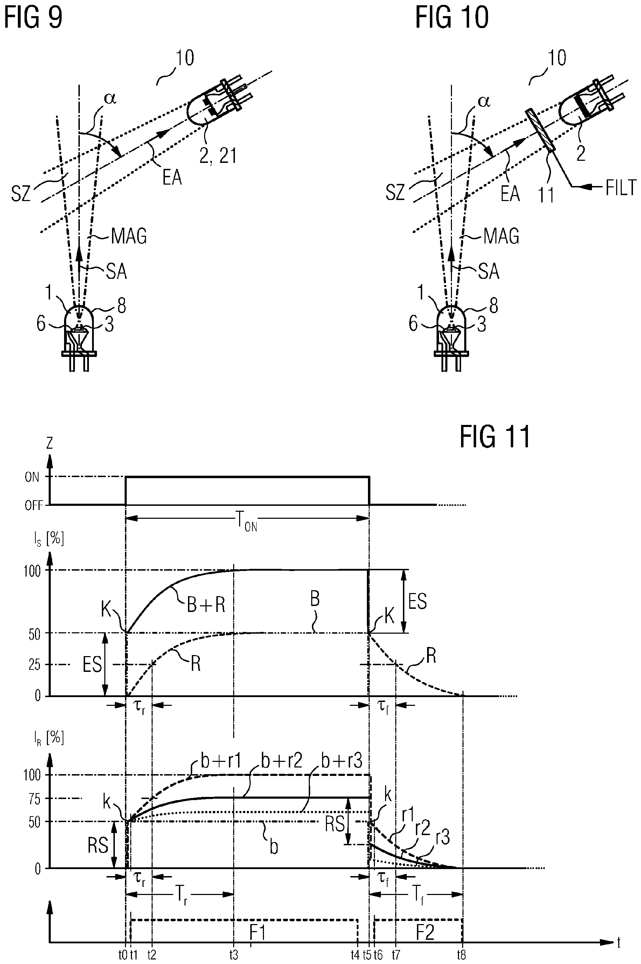

FIG 9 zeigt eine Ausführungsform der erfindungsgemässen Anordnung 10 zur optischen Streulichtdetektion mit einer Leuchtdiode 1 mit vorzugsweise fluoreszierendem Leuchtstoff 6 und mit einem zweikanaligen Photosensor 21. Bei der gezeigten Anordnung handelt es sich um eine sogenannte Vorwärtstreulichtanordnung mit einem Streulichtwinkel α von weniger als 90°. Alternativ oder zusätzlich kann die gezeigte Streulichtanordnung eine Rückwärtsstreulichtanordnung mit einem Streulichtwinkel α von mehr als 90° oder eine kombinierte Vorwärts-/Rückwärtsstreulichtanordnung sein. Der zweikanalige Photosensor 21 weist zwei benachbarte, nicht näher bezeichnete Photosensoreinheiten auf, die mit dem Photosensor 21 im Bezug auf die Leuchtdiode 1 so angeordnet und ausgerichtet sind, dass beide Photosensoreinheiten im Wesentlichen das gleiche Streulicht aus dem gemeinsamen Streulichtzentrum SZ empfangen. Es ist weiter zumindest einer der Photosensoreinheiten ein optisches Filter vorgeschaltet, welches Licht im ersten Wellenlängenbereich, im zweiten Wellenlängenbereich oder in beiden Wellenlängenbereichen passieren lässt. Somit stehen pro Lichtpuls bei elektrischer Erregung der Leuchtdiode 1 zwei Photosensorsignale zur Verfügung, die zumindest mittelbare einer ersten und zweiten Lichtintensität für den ersten und zweiten Wellenlängenbereich zugeordnet und ausgewertet werden können. Für den Fall, dass einer der Photosensoreinheiten kein Filter vorgeschaltet ist, lässt sich die jeweils andere Lichtintensität aus der Wurzel der Differenz aus dem Quadrat der gesamten "filterlosen" Lichtintensität und aus dem Quadrat der jeweils anderen Lichtintensität ermitteln. Das jeweilige optische Filter ist üblicherweise ein Bandpassfilter mit einer Durchlassbandbreite im Bereich von 25 nm bis 100 nm.

FIG 10 zeigt eine weitere Ausführungsform der erfindungsgemässen Anordnung 10 zur optischen Streulichtdetektion mit einer Leuchtdiode 1 mit vorzugsweise fluoreszierendem Leuchtstoff 6, mit einem einkanaligen Photosensor 2 und mit einem elektrisch umschaltbarem optischen Filter 11. Das optische Filter 11 ist dazu ausgestaltet bzw. eingerichtet, Licht von zumindest einer der beiden Wellenlängenbereiche in alternierenden Phasen passieren zu lassen. Zudem ist eine mit der Leuchtdiode 1 und mit dem optischen Filter 11 verbundene Steuereinheit dazu eingerichtet bzw. programmiert, das optische Filter alternierend elektrisch anzusteuern und aus dem jeweiligen, den alternierenden Phasen zeitlich zugeordneten Photosensorsignal das Zweifarben-Verhältnis oder die Zweifarben-Differenz zu bilden. Im einfachsten Fall ist dem elektrisch umschaltbaren Filter 11 ein Bandpassfilter vorgeschaltet, welches Licht eines der beiden Wellenlängenbereiche passieren lässt. Entsprechend dem angesteuerten Zustand des elektrisch ansteuerbaren Filters 11, d.h. eingeschaltet oder ausgeschaltet, passiert dann das auftreffende Licht das Filter 11 oder es wird durch dieses blockiert. Das jeweilige, dem elektrisch ansteuerbaren Filter 11 vorgeschaltete Bandpassfilter weist vorzugsweise eine Durchlassbandbreite im Bereich von 25 nm bis 100 nm.

FIG 11 zeigt ein Zeitdiagramm, welches die gepulste Ansteuerung einer Leuchtdiode mit phosphoreszierendem Leuchtstoff gemäss der Erfindung sowie eine im Vergleich zur spontanen Emission im ersten Wellenlängenbereich zeitverzögerte und nachleuchtende Emission im zweiten Wellenlängenbereich.

Mit t (für Zeit) sind die Abszisse und mit Z, I_{S} und I_{R} die jeweilige Ordinate der Zeitdiagramme bezeichnet. Z ist hier der Schaltzustand der Leuchtdiode gemäss der Erfindung mit den Zustandswerten ON und OFF für ein- oder ausgeschaltet.
I_{S} bezeichnet eine auf 100 % normierte, von der Leuchtdiode emittierte Lichtintensität bzw. Lichtleistung und I_{R} die durch einen Photosensor empfangene Streulichtintensität. Der zuvor genannten 100 %-Wert entspricht der maximalen, von der Leuchtdiode abgegebenen Lichtleistung und setzt sich aus einem roten und blauen Lichtanteil R, B bzw. Lichtleistungsanteil zusammen.

Im Zeitpunkt t0 wird die Leuchtdiode gemäss der Erfindung schlagartig eingeschaltet und leuchtet für eine Einschaltzeitdauer T_{ON} bis zum Zeitpunkt t5, in dem die Leuchtdiode schlagartig wieder ausgeschaltet wird. Die Einschaltzeitdauer T_{ON} liegt vorzugsweise in einem Bereich von 0.2 bis 10 ms.

Im zweiten Zeitdiagramm ist dargestellt, wie unmittelbar nach elektrischer Erregung der Leuchtdiode die emittierte Lichtintensität I_{S} in Form eines abrupten Signalanstiegs ES von einem Wert von 0 % auf einen beispielhaften Wert von 50 % springt. Die Leuchtdiode emittiert dabei zunächst nur blaues Licht (siehe punktgestrichelter Verlauf des blauen Lichtanteils B). Zugleich steigt unmittelbar nach elektrischer Erregung auch der von der Leuchtdiode, d.h. vom Lichtkonverter der Leuchtdiode, emittierte rote Lichtanteil R stetig an und zwar beginnend von einem 0 %-Wert mit einer Anstiegshalbwertszeit τᵣ. Der rote Lichtanteil R nähert sich asymptotisch einem maximalen Wert an, der hier dem beispielhaften 50 %-Wert entspricht (siehe gestrichelter Verlauf des roten Lichtanteils R). Im Zeitpunkt t2 erreicht der rote Lichtanteil R die Hälfte des 50 %-Werts. Der 50 %-Wert wird in etwa nach 5 bis 7 Anstiegshalbwertszeiten τᵣ im Zeitpunkt t3 erreicht. Das Summensignal B+R aus beiden Lichtanteilen B, R bildet im zeitlichen Verlauf somit eine Knickstelle K aus und erreicht gleichfalls nach etwa 5 bis 7 Anstiegshalbwertszeiten τᵣ in etwa den maximalen Wert für die emittierte Lichtintensität I_{S} bzw. Lichtleistung (siehe durchgezogener Verlauf der Summe B+R aus beiden Lichtanteilen B, R).

In entsprechender Weise fällt unmittelbar nach dem Ausschalten der Leuchtdiode und bedingt durch den unmittelbar folgenden Wegfall des emittierten Blauanteils B die gesamte Lichtintensität I_{S} vom stationären 100 %-Wert auf einen Wert von 50 %. Die Leuchtdiode emittiert von diesem Zeitpunkt t5 an nur noch rotes Licht mit einer Abklinghalbwertszeit τ_{f}. Im Zeitpunkt t7 ist dieser Lichtanteil R um 50 % abgefallen. Der rote Lichtanteil R resultiert durch die Phosphoreszenz eines oder mehrere Leuchtstoffe im Lichtkonverter. Der Lichtkonverter glüht sozusagen nach. Nach ca. 5 bis 7 Abklinghalbwertszeiten τ_{f} emittiert die Leuchtdiode faktisch kein Licht mehr.

Im dritten Diagramm ist der beispielhafte relative Verlauf dreier vom Photosensor ausgegebener Photosensorsignale bzw. Streulichtsignale b+r1, b+r2, b+r3 dargestellt, welches von Streulicht an grossen, mittleren und kleinen Rauchteilchen in einem Streulichtzentrum resultiert. Das jeweilige Streulichtsignal b+r1, b+r2, b+r3 setzt sich additiv aus einem blauen Streulichtsignal b sowie aus einem roten Streulichtsignal r1, r2, r3 zusammen. Im vorliegenden Diagramm wurde das von den unterschiedlich grossen Rauchteilchen detektierte blaue Streulichtsignal b auf einen Wert von 50 % normiert. Entsprechend dieser Normierung weist das normierte Streulichtsignal b+r1, b+r2, b+r3 umso grössere relative Lichtintensitätswerte auf, je grösser die Rauchteilchen sind. Umgekehrt ist das zu bestimmende Verhältnis aus dem blauen Streulichtsignal b und aus dem jeweiligen roten Streulichtsignal r1, r2, r3 umso kleiner, je grösser die Rauchteilchen sind.

Das blaue Streulichtsignal b resultiert von blauem Streulicht an Rauchteilchen unmittelbar nach dem Einschalten der Leuchtdiode und springt abrupt von einem 0 %-Wert auf den auf 50 % normierten Wert in Form eines abrupten Signalanstiegs RS. Das erste rote Streulichtsignal r1 resultiert von rotem Streulicht an grossen Rauchteilchen. Das rote Streulichtsignal r1 steigt ausgehend von einem 0 %-Wert entsprechend der Anstiegshalbwertszeit τᵣ des von der Leuchtdiode emittierten roten Lichtanteils R stetig an und nähert sich asymptotisch einem maximalen Wert von 50 %. Das normierte Streulichtsignal b+r1 erreicht somit nach etwa 5 bis 7 Anstiegshalbwertszeiten τᵣ den gezeigten 100 %-Wert und zeigt analog zum zweiten Diagramm wieder eine Knickstelle k. Das zweite rote Streulichtsignal r2 resultiert von rotem Streulicht an mittleren Rauchteilchen und das dritte Streulichtsignal r3 von rotem Streulicht an kleinen Rauchteilchen. In entsprechender Weise steigen die beiden roten Streulichtsignale r2, r3 um einen beispielhaften Wert von 25 % bzw. um etwa 10 %.

In entsprechender Weise fällt das jeweilige rote Streulichtsignal r1, r2, r3 nach dem Ausschalten der Leuchtdiode und bedingt durch den unmittelbar folgenden Wegfall des blauen Streulichtsignals b um einen Wert von 50 % vom jeweiligen stationären 100 %-, 75 %- und 60 %-Wert. Der Photosensor detektiert von diesem Zeitpunkt t5 an nur noch rotes Streulicht r1, r2, r3 mit einer Abklinghalbwertszeit τ_{f}. Nach ca. 5 bis 7 Abklinghalbwertszeiten τ_{f} ist faktisch kein Streulicht mehr durch den Photosensor detektierbar.

Im unteren Diagramm sind beispielhaft zwei Messzeitfenster F1, F2 dargestellt, welche zum Erfassen und Auswerten eines Streulichtsignals b+r1, b+r2, b+r3 geeignet sind, um das Zweifarben-Verhältnis bzw. die Zweifarben-Differenz zu ermitteln. Mit Tᵣ und T_{f} sind eine Einschwingzeitdauer und eine Ausschwingzeitdauer zwischen den Zeitpunkten t0 bis t3 bzw. t5 bis t8 bezeichnet, innerhalb derer das Streulichtsignal b+r1, b+r2, b+r3 nicht stationär ist. Das erste Messzeitfenster F1 erstreckt sich von einem Zeitpunkt t1 bis zu einem Zeitpunkt t4. Im Zeitpunkt t1 liegt das blaue Streulichtsignal b bereits voll an. Der Zeitpunkt t4 zeigt das Ende des stationären Verlaufs des Streulichtsignals b+r1, b+r2, b+r3 kurz vor dem Abschalten der Leuchtdiode an.

Ein aktueller Wert des blauen Streulichtsignals b ist im Zeitpunkt t1 erfassbar, da das rote Streulichtsignal r1-r3 noch vernachlässigbar ist. Ein aktueller Wert für das rote Streulichtsignal r1-r3 kann aus der Differenz des Streulichtsignals b+r1, b+r2, b+r3 und aus dem zuvor erfassten Wert für das blaue Streulichtsignal b ermittelt werden, und zwar während des stationären Verlaufs des Streulichtsignals b+r1, b+r2, b+r3 zwischen den Zeitpunkten t3 und t4. Alternativ kann der aktuelle Wert für das rote Streulichtsignal r1-r3 im Zeitpunkt t6 direkt erfasst werden, also nach dem unmittelbaren Wegfall des blauen Streulichts b nach dem Ausschalten der Leuchtdiode. Weiterhin alternativ kann der aktuelle Wert für das rote Streulichtsignal r1-r3 in der nichtstationären Phase des Streulichtsignals b+r1, b+r2, b+r3 ermittelt werden, wie z.B. in den Zeitpunkten t2 oder t7, in denen aufgrund der bekannten Anstiegs- und Abklinghalbwertszeit τᵣ, τ_{f} die Hälfte des Anstiegs des roten Streulichtsignals r1-r3 anliegt.

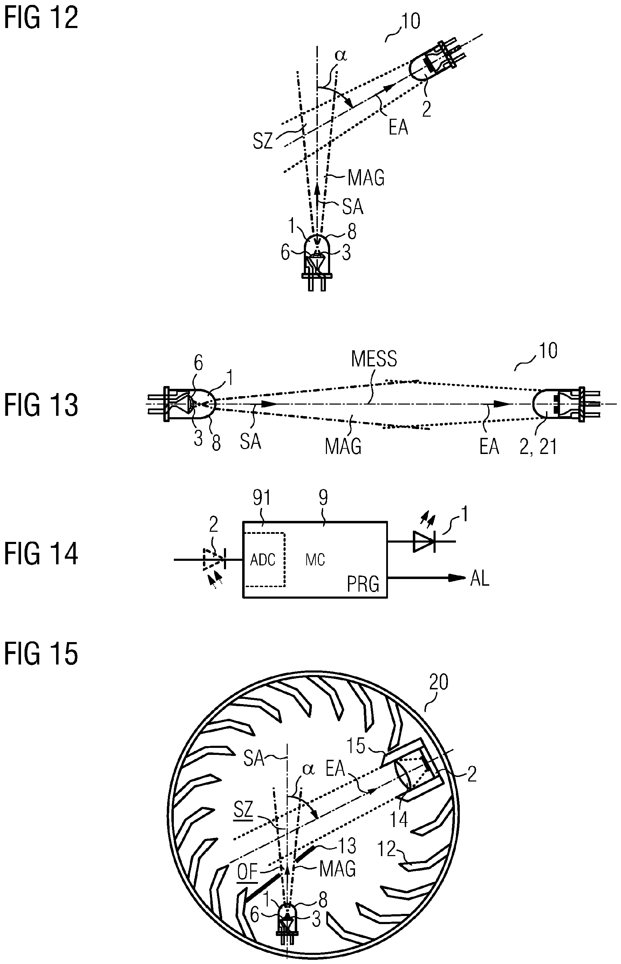

FIG 12 zeigt eine Ausführungsform der erfindungsgemässen Anordnung 10 zur optischen Streulichtdetektion mit einer Leuchtdiode 1 mit phosphoreszierendem Leuchtstoff und mit einem einkanaligen Photosensor 2.

Gemäss der Erfindung erfolgt die Bildung des Zweifarben-Verhältnisses bzw. der Zweifarben-Differenz durch eine Auswertung des zeitlichen Verlaufs des vom Photosensor stammenden Streulichtsignals. Dieses Streulichtsignal weist abhängig von der Rauchteilchengrösse und somit vom Rauchtyp zeitlich sich ändernde Lichtanteile des ersten und zweiten Wellenlängenbereichs innerhalb eines Lichtpulses auf. Die gepulste Ansteuerung der Leuchtdiode 1 sowie die messtechnische Erfassung des Streulichtsignals erfolgt vorzugsweise mittels einer elektronischen Steuereinheit, wie z.B. mittels eines Mikrocontrollers. Die Steuereinheit ist dazu eingerichtet, in Abhängigkeit vom ermittelten Rauchtyp und bei Überschreiten eines Mindestpegels des Streulichtpegels, vorzugsweise bei Überschreiten des dem ersten Wellenlängenbereich zugeordneten Streulichtpegels, einen Brandalarm auszugeben.

FIG 13 zeigt eine Ausführungsform der erfindungsgemässen Anordnung 10 zur Durchlichtmessung entlang einer Messstrecke MESS mit einer Leuchtdiode 1 mit fluoreszierendem Leuchtstoff und mit einem zweikanaligen Photosensor 21. Der Photosensor 21 weist zwei benachbarte Photosensoreinheiten, die zum Empfang von direktem Licht von der Leuchtdiode 1 ausgerichtet sind. Analog zum Beispiel gemäss der FIG 9 ist zumindest einer der Photosensoreinheiten ein optisches Filter vorgeschaltet, welches Licht im ersten Wellenlängenbereich, im zweiten Wellenlängenbereich oder in beiden Wellenlängenbereichen passieren lässt. Die Steuereinheit ist dazu eingerichtet, in Abhängigkeit vom Verhältnis oder von der Differenz der beiden erfassten Sensorsignale der Photosensoreinheiten und somit vom ermittelten Rauchtyp sowie bei Unterschreiten eines Mindestpegels zumindest eines der beiden Sensorsignale der Photosensoreinheiten einen Brandalarm auszugeben.

FIG 14 zeigt ein Beispiel für eine Steuereinheit 9 für eine Rauchdetektionseinheit gemäss der Erfindung. Die gezeigte Steuereinheit 9 ist vorzugsweise ein Mikrocontroller. Er kann, wie im vorliegenden Beispiel, bereits einen integrierten A/D-Umsetzer 91 zur Erfassung eines Photosensorsignals vom Photosensor 2 aufweisen. Zudem weist er einen Ausgang zum gepulsten Ansteuerung einer Leuchtdiode 1 gemäss der Erfindung sowie einen Ausgang zur Ausgabe eines Brandalarms AL im detektierten Brandfall auf. Mit PRG ist ein Computerprogramm bezeichnet, welches im Mikrocontroller 9 geladen ist und durch diesen zur Durchführung der optischen Rauchdetektion ausgeführt wird. Hierzu weist das Computerprogramm PRG geeignete Programmschritte auf.

Abschliessend zeigt FIG 15 ein Beispiel für eine Rauchdetektionseinheit 20 geschlossener Bauart mit einer erfindungsgemässen Streulichtanordnung 10.

Derartige Rauchmelder werden auch als Brandmelder bezeichnet. Sie weisen typischerweise ein Gehäuse mit zumindest einer Raucheintrittsöffnung sowie die im Gehäuse aufgenommene Rauchdetektionseinheit 20 auf. Die Rauchdetektionseinheit 20 umfasst vorzugsweise eine gegen Umgebungslicht abgeschirmte, jedoch für zu detektierenden Rauch durchlässige optische Messkammer. Letztere weist typischerweise auch eine Vielzahl von Umgebungslicht abschirmenden Lamellen 12 auf und wird daher auch als Labyrinth bezeichnet.

Beide Bauelemente sind typischerweise elektrisch mit einer Leiterplatte verbunden, die sich üblicherweise ausserhalb der Detektionseinheit 10 befindet und an diese angrenzt. Auf der Leiterplatte können weitere Bauelemente angeordnet sein wie z.B. ein Mikrocontroller, aktive oder passive Bauelemente.

Die Leuchtdiode 1 weist ein Kunststoffgehäuse 8 auf, welches eine optische Linse zur Lichtbündelung des von der Leuchtdiode 1 erzeugten Lichts in Richtung einer Blendenöffnung OF ausbildet. Die gezeigte Leuchtdiode 1 entspricht in ihrem äusseren Erscheinungsbild dem einer typischen 5 mm-Leuchtdiode für eine "Through-Hole-Montage" mit einem Durchmesser des Kunststoffgehäuses von 5 mm. Mit dem Bezugszeichen 13, 15 ist eine Blende für die Leuchtdiode 1 und für den Photoempfänger 2 bezeichnet. Mit dem Bezugszeichen 14 ist eine optische Empfängerlinse für den Photosensor 2 bezeichnet. Der Photosensor 2 ist vorzugsweise eine Photodiode, insbesondere eine Silizium-PIN-Photodiode und vorzugsweise eine Silizium-PIN-Photodiode mit erhöhter Blauempfindlichkeit.

### SCHLUSSBEMERKUNG

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

### Bezugszeichenliste

- 1, 1': (Zweifarben-)Leuchtdiode, LED, Laserdiode
- 2: Photosensor, Halbleiter-Photodiode, Silizium-PIN-Photodiode
- 3: blauer LED-Chip, UV-LED-Chip, Flächenstrahler
- 4: roter LED-Chip, IR-LED-Chip, Flächenstrahler
- 5: Träger, Trägerplatte
- 6: Lichtkonversionsschicht, Lichtkonverter
- 7: Anschlusskontakte
- 8: Gehäuse, Kunststoffgehäuse, LED-Gehäuse
- 9: Steuereinheit, Mikrocontroller
- 10, 10': Anordnung
- 11: umschaltbares optisches Filter
- 12: Lamelle, Lichtabschirmelement
- 13: Blende, Lochblende
- 14: optische Linse, Empfängerlinse
- 15: Empfängerblende
- 20: Rauchdetektionseinheit, optische Messkammer, Rauchmesskammer
- 21: Zweikanal-Photosensor, Zweikanal-Photodiode
- 71, 72: Anschlusskontakte
- 91: Analog/Digital-Umsetzer, ADC
- α: Streulichtwinkel
- τᵣ, τ_{f}: Anstiegshalbwertszeit, Abklinghalbwertszeit
- AL: Alarm, Alarminformation
- b: blaues Streulichtsignal, normiert
- B: emittierter blauer Lichtanteil
- B+R: gesamtes emittiertes Licht
- b+r1, b+r2, b+r3: relatives Streulichtsignal
- BB: Bandbreite des blauen Peaks, Halbwertsbreite
- BL: Lichtbündel, "blaues" Lichtbündel
- BP: blauer Peak, signifikanter blauer Spitzenwert, blaues Spektralband, blaue Spektrallinie
- BR: Bandbreite des roten Peaks, Halbwertsbreite
- B2: Bandbreite des farbigen Peaks, Halbwertsbreite
- BR: Lichtbündel, "rotes" Lichtbündel
- EA: Empfangsachse, optische Achse
- ES: abrupter Signalanstieg (LED-seitig)
- F1-F3: Messzeitfenster
- FILT: Filterumschaltsignal
- k, K: Knick, Knickstelle, Sprung
- LI: optische Linse, LED-Linse
- LI': separate Linseneinheit mit Lichtkonverter
- LU: Mindestbandbreite, Bandlücke
- M1, M2: Wellenlängenspitzenwert, Maximum
- MAG: magentafarbenes Lichtbündel
- MAX: maximaler relativer Lichtstrom
- MESS: Messstrecke
- MG1, MG2: Spektrum einer magentafarbenen LED
- OF: Blendenöffnung
- PRG: Softwareprogamm, Computerprogrammprodukt
- r1-r3: rotes Streulichtsignal, normiert
- R: emittierter roter Lichtanteil
- RS: abrupter Signalanstieg (photosensorseitig)
- RP: roter Peak, signifikanter roter Spitzenwert, rotes Spektralband, rote Spektrallinie
- SA: Sendeachse, Symmetrieachse der LED, geometrische Hauptachse der LED
- SP1, SP2: Spektrum einer weissen LED
- SZ: Streulichtzentrum
- T_{ON}: Einschaltzeitdauer
- Tᵣ, T_{f}: Wartezeit, Integrationszeit
- Z: Schaltzustand

## Patentansprüche

1. Anordnung zur optischen Rauchdetektion nach dem Zweifarben-Prinzip, wobei die Anordnung eine Leuchtdiode (1) sowie einen spektral darauf abgestimmten Photosensor (2) umfasst, wobei die Leuchtdiode (1) einen LED-Chip (3) zur Emission von Licht in einem ersten Wellenlängenbereich und einen Lichtkonverter (6) zum Umwandeln eines Teils des emittierten Lichts in Licht eines zweiten Wellenlängenbereichs aufweist, und wobei der zweite Wellenlängenbereich eine spektrale Halbwertsbreite (BR) von maximal 100 nm aufweist.

2. Anordnung nach Anspruch 1, wobei der Lichtkonverter (6) zumindest einen Leuchtstoff mit lumineszierenden Eigenschaften aufweist, so dass der relative Lichtstrom Φᵣₑₗ des gesamten emittierten Lichts zwischen einer Hauptwellenlänge λ₁ des ersten Wellenlängenbereichs und einer Hauptwellenlänge λ₂ des zweiten Wellenlängenbereichs einen Lichtstromwert von maximal 15 %, insbesondere von maximal 10 %, bezogen auf einen auf 100 % normierten maximalen Lichtstromwert (M1, M2) im gesamten Emissionsspektrum der Leuchtdiode (1), innerhalb einer Mindestbandbreite (LU) von 100 nm nicht überschreitet.

3. Anordnung nach Anspruch 1 oder 2, wobei der Lichtkonverter (6) direkt auf dem LED-Chip (3) aufgebracht oder beabstandet zum LED-Chip (3) angeordnet ist.

4. Anordnung nach einem der vorherigen Ansprüche, wobei der Lichtkonverter (6) zumindest einen fluoreszierenden Leuchtstoff aufweist, insbesondere aus anorganischen, kristallinen Stoffen mit in der Kristallstruktur eingebrachten Dotierungselementen als Störstellen.

5. Anordnung nach einem der vorherigen Ansprüche, wobei der Lichtkonverter (6) zumindest einen phosphoreszierenden Leuchtstoff aufweist, insbesondere aus anorganischen, kristallinen Stoffen mit in der Kristallstruktur eingebrachten Dotierungselementen als Störstellen.

6. Anordnung nach Anspruch 5, wobei der zumindest eine Leuchtstoff eine Abklinghalbwertszeit (τF) für das Nachleuchten des Leuchtstoffs nach Wegfall der optischen Erregung durch den LED-Chip (3) oder eine Anstiegshalbwertszeit (τR) für das optische Aufladen des Leuchtstoffs beginnend mit der optischen Erregung jeweils im Bereich von 10 µs bis 50 ms, insbesondere in einem Bereich von 50 µs bis 5 ms, aufweist.

7. Rauchdetektionseinheit, welche aufweist
- eine Anordnung (10) nach einem der Ansprüche 1 bis 6, und
- eine Steuereinheit (9), welche mit der Leuchtdiode (1) und mit dem Photosensor (2) verbunden ist, dazu eingerichtet,
- die Leuchtdiode (1) zur Lichtemission anzusteuern,
- ein Photosensorsignal des Photosensors (2) zu erfassen,
- eine erste und zweite Lichtintensität für den ersten und zweiten Wellenlängenbereich aus einer zeitlichen Analyse des Photosensorsignals zu bilden,
- darauf basierend ein Zweifarben-Verhältnis oder eine Zweifarben-Differenz zu bilden, und
- das Zweifarben-Verhältnis oder die Zweifarben-Differenz bei der Brandalarmierung (AL) mit zu berücksichtigen.

8. Rauchdetektionseinheit nach Anspruch 7, wobei der Photosensor (2) als Zweikanal-Photosensor (21) ausgebildet ist und zwei Photosensoreinheiten aufweist, wobei zumindest einer der zwei Photosensoreinheiten ein optisches Filter vorgeschaltet ist, welches Licht im ersten Wellenlängenbereich oder im zweiten Wellenlängenbereich passieren lässt, und wobei die Steuereinheit (9) dazu eingerichtet ist, aus den beiden erfassten Lichtintensitäten des Photosensors (2) das Zweifarben-Verhältnis oder die Zweifarben-Differenz zu bilden.

9. Rauchdetektionseinheit nach Anspruch 7, wobei der Photosensor (2) als Einkanal-Photosensor ausgebildet ist, wobei dem Einkanal-Photosensor (2) ein elektrisch umschaltbares optisches Filter (11) vorgeschaltet ist, welches zum Ausfiltern von Licht zumindest eines der beiden Wellenlängenbereiche in alternierenden Phasen eingerichtet ist, wobei die Steuereinheit (9) dazu eingerichtet ist, das optische Filter (11) alternierend elektrisch anzusteuern und dazu eingerichtet ist, das Zweifarben-Verhältnis oder die Zweifarben-Differenz aus den jeweiligen, den alternierenden Phasen zeitlich zugeordneten Lichtintensitäten des Photosensorsignals zu bilden.

10. Rauchdetektionseinheit nach Anspruch 7 in Verbindung mit einer Anordnung (10) nach Anspruch 6, wobei die Steuereinheit (9) dazu eingerichtet ist, das Zweifarben-Verhältnis oder die Zweifarben-Differenz aus der Höhe eines abrupten Signalanstiegs (RS) des erfassten Photosensorsignals unmittelbar nach dem Einschalten der Leuchtdiode (1) zu ermitteln und/oder dazu eingerichtet ist, das Zweifarben-Verhältnis oder die Zweifarben-Differenz aus der Höhe eines abrupten Signalabfalls (RS) des erfassten Photosensorsignals unmittelbar nach dem Ausschalten der Leuchtdiode (1) zu ermitteln.

11. Streulichtrauchmelder, mit einem Gehäuse und mit einer im Gehäuse aufgenommenen Rauchdetektionseinheit nach einem der Ansprüche 7 bis 10, wobei die Leuchtdiode (1) und der Photosensor (2) in einer Streulichtanordnung angeordnet und auf ein gemeinsames Streulichtzentrum (SZ) ausgerichtet sind, wobei das Gehäuse Raucheintrittsöffnungen für den Durchtritt von Umgebungsluft in das Innere des Gehäuses aufweist und wobei das Gehäuse gegen das Eindringen von direktem Umgebungslicht in das Innere des Gehäuses abgeschirmt ist.

12. Extinktions-Rauchmelder, mit einem Gehäuse und mit einer im Gehäuse aufgenommenen Rauchdetektionseinheit nach einem der Ansprüche 7 bis 10, wobei die Leuchtdiode (1) und der Photosensor (2) derart angeordnet sind, dass der Photosensor (2) direktes Licht von der Leuchtdiode (1) detektiert, wobei das Gehäuse Raucheintrittsöffnungen für den Durchtritt von Umgebungsluft in das Innere des Gehäuses aufweist und wobei das Gehäuse gegen das Eindringen von direktem Umgebungslicht in das Innere des Gehäuses abgeschirmt ist.

13. Offener Streulichtrauchmelder, mit einem Gehäuse und mit einer am Gehäuse aufgenommenen Rauchdetektionseinheit nach einem der Ansprüche 7 bis 10, wobei die Leuchtdiode (1) und der Photosensor (2) im oder am Gehäuse angeordnet und optisch auf ein gemeinsames Streulichtzentrum (SZ) ausgerichtet sind, wobei das Streulichtzentrum (SZ) ausserhalb des Streulichtrauchmelders im Freien liegt.

14. Verwendung einer Leuchtdiode (1) für die optische Rauchdetektion nach dem Zweifarben-Prinzip, wobei die Leuchtdiode (1) einen LED-Chip (3) zur gepulsten Lichtemission in einem ersten Wellenlängenbereich sowie einen Lichtkonverter (6) mit zumindest einem Leuchtstoff zum Umwandeln eines Teils des emittierten Lichts in Licht eines zweiten Wellenlängenbereichs aufweist, wobei der zweite Wellenlängenbereich eine spektrale Halbwertsbreite (BR) von maximal 100 nm, insbesondere von maximal 50 nm, aufweist.

15. Verwendung einer Leuchtdiode (1) nach Anspruch 14 zur gepulsten Lichtemission mit sich zeitlich ändernden Lichtanteilen des ersten und zweiten Wellenlängenbereichs innerhalb eines Lichtpulses, wobei der zumindest eine Leuchtstoff eine Abklinghalbwertszeit (τF) für das Nachleuchten des Leuchtstoffs nach Wegfall der optischen Erregung durch den LED-Chip (3) oder eine Anstiegshalbwertszeit (τR) für das optische Aufladen des Leuchtstoffs beginnend mit der optischen Erregung durch den LED-Chip (3) jeweils im Bereich von 10 µs bis 50 ms, insbesondere in einem Bereich von 50 µs bis 5 ms, aufweist, und wobei das Zweifarben-Verhältnis oder die Zweifarben-Differenz aus den sich zeitlich ändernden Lichtanteilen innerhalb eines Lichtpulses gebildet wird.
